# DEMANDE DE BREVET EUROPEEN

(11) **EP 3 240 041 A1**
(43) Date de publication de la demande: **01.11.2017**
(21) Numéro de dépôt: 17166076.4
(22) Date de dépôt: 11.04.2017
(51) Int. Cl.: H01L 29/778, H01L 29/06, H01L 29/423, H01L 29/10, H01L 29/20

(54) **TRANSISTOR À HETEROJONCTION DE TYPE NORMALEMENT OUVERT A TENSION DE SEUIL ELEVEE**

(30) Priorité: 29.04.2016 FR 1653905
(71) Demandeur: COMMISSARIAT À L'ÉNERGIE ATOMIQUE ET AUX ÉNERGIES ALTERNATIVES, 75015 Paris (FR)
(72) Inventeur: BAINES, Yannick, 38000 GRENOBLE (FR); BUCKLEY, Julien, 38000 GRENOBLE (FR)
(74) Mandataire: GIE Innovation Competence Group

(57) **Abrégé**

L'invention concerne un transistor à effet de champ (1) à haute mobilité électronique de type normalement ouvert, comprenant :
-une superposition d'une première couche de matériau semi-conducteur (15) et d'une deuxième couche de matériau semi-conducteur (16) de façon à former une couche de gaz d'électrons (17) à l'interface de l'interface entre ces première et deuxième couches;
-une tranchée (5) séparant la superposition en des premier et deuxième domaines (51, 52) ;
-un élément isolant (34) disposé dans ladite tranchée pour isoler électriquement lesdits premier et deuxième domaines;
-un élément semi-conducteur (33) à dopage de type P en contact avec la première ou la deuxième couche de matériau semi-conducteur (16) des premier et deuxième domaines (51,52), et s'étendant en continu entre les premier et deuxième domaines ;
-un isolant de grille (32) disposé sur l'élément semi-conducteur (33) ;
-une électrode de grille (31) disposée sur l'isolant de grille (32).

## Description

L'invention concerne les transistors de puissance à hétérojonction, et en particulier les transistors de puissance à hétérojonction de type normalement ouvert.

De nombreuses applications électroniques nécessitent dorénavant une amélioration de performances surtout dans l'électronique embarquée à destination de l'automobile et des transports terrestres, dans l'aéronautique, dans les systèmes médicaux ou dans des solutions domotiques par exemple. Ces applications nécessitent pour la plupart des commutateurs pour forte puissance fonctionnant dans des gammes de fréquences fréquemment supérieures au megahertz.

Historiquement, des commutateurs de puissance ont longtemps fait appel à des transistors à effet de champ basés sur un canal semi-conducteur, le plus souvent du silicium. Pour des fréquences plus faibles, les transistors à jonction sont préférés car ils supportent des densités de courant plus élevées. Cependant, du fait de la tension de claquage relativement limitée de chacun de ces transistors, les applications de puissance nécessitent l'utilisation d'un grand nombre de transistors en série, ou des transistors plus longs, ce qui aboutit à une résistance de passage plus élevée. Les pertes à travers ces transistors en série sont considérables, aussi bien en régime établi qu'en commutation.

Une alternative pour des commutateurs de puissance, notamment à hautes fréquences, est l'utilisation de transistors à effet de champ à hétérojonction, également désignés par le terme de transistor à effet de champ à hétérostructure. De tels transistors incluent notamment les transistors à haute mobilité électronique dits HEMT.

En particulier, un transistor à haute mobilité électronique inclut la superposition de deux couches semi-conductrices ayant des bandes interdites différentes qui forment un puit quantique à leur interface. Des électrons sont confinés dans ce puits quantique pour former un gaz bidimensionnel d'électrons. Pour des raisons de tenue en haute tension et en température, ces transistors sont choisis de façon à présenter une large bande d'énergie interdite.

Pour certaines applications, notamment des applications de sécurité en vue d'isoler un circuit en cas de dysfonctionnement d'un système de commande, on utilise des transistors HEMT du type normalement ouvert ou normalement bloqué, c'est-à-dire que leur tension de seuil de commutation est positive, de sorte que le transistor reste bloqué en l'absence de signal de commande. Il existe un besoin pour de tels transistors présentant une tension de seuil relativement élevée, typiquement d'au moins 3 V.

Du fait de la nature intrinsèquement conductrice de la couche de gaz d'électrons formée entre une source et un drain, il est technologiquement plus facile de réaliser un transistor à hétérojonction de type normalement passant. Cependant, plusieurs procédés de fabrication ont été développés en vue de former des transistors à hétérojonction de type normalement ouvert ou normalement bloqué.

Le document US2014/077267 décrit un transistor à effet de champ à haute mobilité électronique de type normalement ouvert. Une tranchée isolante s'étend dans une couche de matériau semi-conducteur en matériau III-V.

Le document US8664696 décrit un transistor HEMT de type normalement ouvert. Le transistor comporte l'empilement de couches suivant :
- un substrat en Saphire ;
- une couche tampon de nitrure, formée sur le substrat ;
- une couche de GaN non intentionnellement dopé, formée sur la couche tampon ;
- une couche de GaN à dopage de type P, formée sur la couche de GaN non intentionnellement dopé ;
- une couche de GaN à dopage de type N, formée sur la couche de GaN à dopage de type P ;
- une couche d'AlGaN à dopage de type N, formée sur la couche de GaN à dopage de type N.

Une couche de gaz d'électrons est formée à proximité de l'interface entre la couche d'AlGaN et la couche de GaN à dopage de type N. Une source et un drain sont formés en contact avec la couche d'AlGaN. Une tranchée est formée à travers la couche d'AlGaN, à travers la couche de GaN à dopage de type N et s'étend jusqu'à la couche de GaN à dopage de type P. Un isolant de grille est interposé entre les parois de la tranchée et une électrode de grille formée à l'intérieur de la tranchée.

De part et d'autre de la tranchée, la conduction vers la source et vers le drain est réalisée à travers la couche de gaz d'électrons. La couche de gaz d'électrons est interrompue par la tranchée de grille.

Lorsque la tension de polarisation de la grille est inférieure à la tension de seuil du transistor, aucun canal de conduction ne connecte les deux parties de la couche de gaz d'électrons de part et d'autre de la tranchée de grille.

Lorsque la tension de polarisation de la grille est supérieure à la tension de seuil du transistor, un canal d'inversion est formé dans la couche de GaN de type P sous la tranchée de grille. Les électrons provenant du drain peuvent alors traverser ce canal d'inversion pour atteindre la source par l'intermédiaire de la couche de GaN de type N.

Un tel transistor présente une tension de seuil relativement élevée et la couche de GaN à dopage de type P limite la conduction parasite d'électrons en profondeur en jouant le rôle de barrière arrière.

Cependant, un tel transistor présente des inconvénients. En effet, la couche de GaN dopée P est généralement formée par épitaxie. Le profil de dopage de cette couche de GaN dopée P est délicat à maîtriser, en particulier lorsque le dopant est du Magnésium. Par ailleurs, pour une couche de GaN dopée N d'épaisseur réduite, le gaz d'électrons est affecté par la proximité de la couche de GaN dopée P, ce qui conduit à une résistance de conduction élevée du transistor. A contrario, pour une couche de GaN dopée N d'épaisseur élevée, la tranchée doit être plus profonde. Une telle profondeur de la tranchée induit des résistances de transition autour du fond de la tranchée, conduisant à une résistance de conduction élevée du transistor. Par ailleurs, on obtient une résistance de conduction élevée à travers la couche de GaN dopée P formée par épitaxie avant la formation de la tranchée.

L'invention vise à résoudre un ou plusieurs de ces inconvénients. L'invention porte ainsi sur un transistor à effet de champ à haute mobilité électronique de type normalement ouvert, tel que défini à la revendication 1. L'invention porte également sur un procédé de fabrication, tel que défini à la revendication 15.

L'invention porte également sur les variantes définies dans les revendications dépendantes. L'homme du métier comprendra que chacune des caractéristiques des variantes des revendications dépendantes peut être combinée indépendamment aux caractéristiques des revendications indépendantes, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe transversale d'un transistor HEMT de type normalement ouvert selon un exemple d'un premier mode de réalisation de l'invention, en configuration d'ouverture ;
- la figure 2 est une vue en coupe transversale du transistor de la figure 1, en configuration de fermeture;
- la figure 3 est une vue en coupe transversale d'un transistor HEMT de type normalement ouvert selon un exemple d'un deuxième mode de réalisation de l'invention, en configuration d'ouverture ;
- la figure 4 est une vue en coupe transversale du transistor de la figure 3, en configuration de fermeture;
- la figure 5 est une vue en coupe transversale d'un transistor HEMT de type normalement ouvert selon un exemple d'un troisième mode de réalisation de l'invention, en configuration d'ouverture ;
- la figure 6 est une vue en coupe transversale du transistor de la figure 5, en configuration de fermeture ;
- la figure 7 est une vue en coupe transversale d'un transistor à haute mobilité électronique de type normalement ouvert selon un exemple d'un quatrième mode de réalisation de l'invention, en configuration d'ouverture ;
- la figure 8 est un diagramme illustrant différentes étapes mise en oeuvre lors de la fabrication d'un transistor selon l'invention.

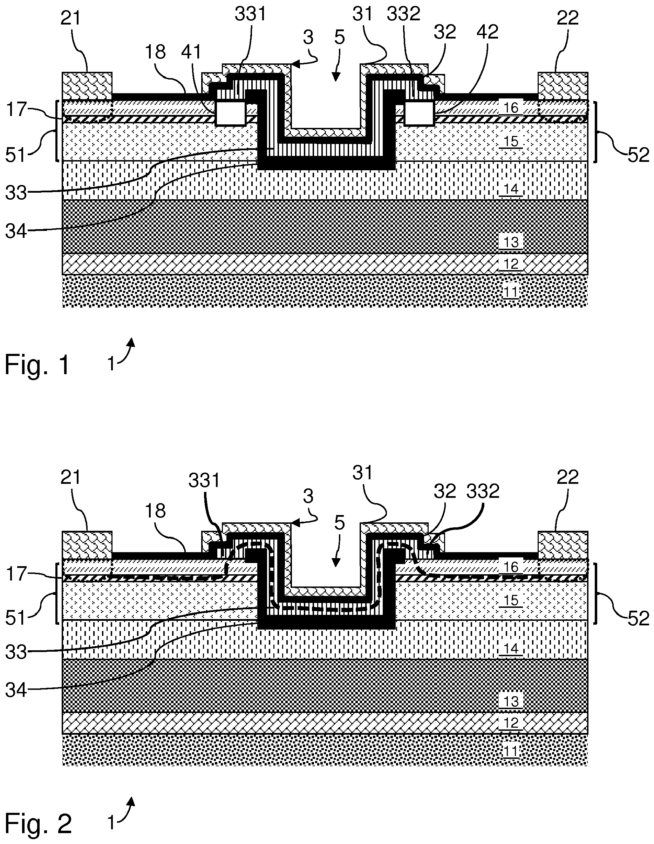

La figure 1 est une vue en coupe transversale d'un transistor à haute mobilité électronique 1 de type normalement ouvert selon un exemple d'un premier mode de réalisation de l'invention. À la figure 2, le transistor 1 est illustré à l'état passant. Le trait discontinu de la figure 2 illustre le chemin de conduction.

Le transistor 1 comporte un substrat 11. Le substrat 11 peut par exemple être un isolant électrique ou un matériau semi-conducteur de type silicium intrinsèque ou dopé P. Le substrat 11 pourra par exemple être de type silicium à orientation de maille (111). Le substrat 11 peut également être du carbure de silicium, ou du saphir. Le substrat 11 peut présenter une épaisseur de l'ordre de 650 µm, typiquement comprise entre 500 µm et 2mm.

Le transistor 1 comporte ici avantageusement une (ou plusieurs) couche d'adaptation (non illustrée) disposée sur le substrat 11. La couche d'adaptation peut être déposée de façon connue en soi sur le substrat 11, et sert d'intermédiaire entre le substrat 11 et une couche tampon de matériau semi-conducteur 12, pour permettre une adaptation de maille entre le substrat 11 et la couche 12. La couche d'adaptation peut typiquement être en nitrure d'aluminium.

Le transistor 1 comporte ainsi avantageusement une couche de matériau semi-conducteur 12 formant une couche dite tampon ayant pour rôle la gestion des contraintes mécaniques et participant à l'isolation électrique verticale de la structure. La couche 12 peut être réalisée via l'emploi d'un seul matériau semiconducteur III-N, tel que du GaN non intentionnellement dopé. Elle peut également être réalisée via l'empilement de différents matériaux semiconducteurs III-N, tel qu'un super réseau AlₓGa₁₋ₓN/GaN. La couche semi conductrice 12 peut typiquement présenter une épaisseur comprise entre 100nm et 5µm. La couche semi conductrice 12 peut être formée de façon connue en soit par épitaxie sur la couche d'adaptation.

Le transistor 1 comporte une couche 13 en matériau semi-conducteur de type alliage III-V (par exemple un alliage binaire de type III-V, par exemple en nitrure d'élément III, typiquement du GaN) participant à l'isolation électrique verticale de la structure. La couche 13 peut par exemple être de type réalisée via l'emploi de GaN dopé au carbone. La couche 13 est ici disposée sur la couche tampon 12 et peut présenter typiquement une épaisseur de 100 nm à 5 µm et un dopage de 1x10¹⁸ cm⁻³ et 1x10¹⁹ cm⁻³.

Le transistor 1 comporte une couche 14 en matériau semi-conducteur de type alliage III-V (par exemple un alliage binaire de type III-V, par exemple en nitrure d'élément III, typiquement du GaN) à dopage de type P. La couche 14 forme une barrière arrière ou barrière enterrée (back barrier en langue anglaise). La couche 14 permet de réduire la conduction parasite d'électrons en profondeur. La couche 14 est ici disposée sur la couche 13. La couche 14 peut typiquement présenter une épaisseur de 50 nm à 200 nm et un dopage Mg dans la gamme de 1x10¹⁷ cm³ et 1x10¹⁸ cm³.

Le transistor 1 comporte une couche 15 en matériau semi-conducteur de type alliage III-V (par exemple un alliage binaire de type III-V, par exemple en nitrure d'élément III, typiquement du GaN). La couche 15 est ici formée sur la couche 14. La couche 15 est par exemple en GaN. La couche est par exemple une couche dite GaN canal. La couche 15 est par exemple de type non intentionnellement dopé ou à dopage de type N+. La couche 15 peut présenter une épaisseur typiquement comprise entre 50 et 500nm.

Le transistor 1 peut comporter une fine couche ALₓGa₁₋ₓN entre la couche dite de GaN canal 15 et la couche barrière 14. Cette couche peut typiquement être en AIN et peut présenter une épaisseur proche de 1 nm. Cette couche dite espaceur (spacer en anglais) a pour but d'accroitre le confinement du gaz d'électrons.

Le transistor 1 comporte en outre une couche 16 en matériau semi-conducteur de type alliage III-V (par exemple un alliage ternaire de type III-V, par exemple en nitrure d'élément III, typiquement de l'AlGaN ou de l'InAlN, ou encore un alliage quaternaire de nitrure d'élément III, par exemple de l'AlₓGa_{y}In_{(1-x-y)}N, en gardant une bande interdite supérieure à celle du matériau de la couche 15). La couche 16, typiquement appelée couche barrière, peut typiquement présenter une épaisseur comprise entre 10nm et 40nm, par exemple de 25nm. Les couches semi-conductrices 15 et 16 sont superposées de façon connue en soi pour former une couche de gaz d'électrons 17 à l'interface ou à proximité de l'interface entre ces couches 15 et 16.

Le transistor 1 comporte en outre un drain 21. Le drain 21 est ici formé sur la couche 16. Le drain 21 est connecté électriquement à la couche de gaz d'électrons 17. Dans l'exemple illustré, le drain 21 est en contact avec la couche 16. Le transistor 1 comporte en outre une source 22. La source 22 est ici formée sur la couche 16. La source 22 est connectée électriquement à la couche de gaz d'électrons 17. Le drain 21 et la source 22 détaillés ne sont fournis qu'à titre illustratif et peuvent présenter d'autres types de structures et connexions que celles détaillées dans cet exemple.

Le transistor 1 comporte en outre une grille de commande 3. Le drain 21 et la source 22 sont disposés de part et d'autre de la grille de commande 3. Une tranchée 5 est formée sous la grille de commande 3. La tranchée 5 traverse les couches 15 et 16 et interrompt ainsi la couche de gaz d'électrons 17. La tranchée 5 sépare ainsi la superposition des couches 15 et 16 et la couche de gaz d'électrons 17 en deux domaines disjoints 51 et 52. La tranchée 5 s'étend ici jusque dans la couche 14 à dopage de type P.

Le transistor 1 comporte un élément de matériau isolant 34. L'élément de matériau isolant 34 isole électriquement les domaines 51 et 52 de la superposition des couches 15 et 16. L'élément 34 interrompt notamment la couche de gaz électrons 17 entre les domaines 51 et 52. L'élément 34 recouvre ici les parois latérales de la tranchée 5 et est donc en contact avec des faces latérales des couches 15 et 16. L'élément 34 recouvre ici la paroi de fond de la tranchée 5, et est donc en contact avec la couche 14 au fond de la tranchée 5. L'élément 34 comporte également des rebords recouvrant une partie de la couche 16 dans les domaines 51 et 52 respectivement.

Le transistor 1 comprend en outre un élément semi-conducteur 33 à dopage de type P. L'élément semi-conducteur 33 est en contact avec une couche de l'empilement des couches 15 et 16 dans le domaine 51 d'une part, et dans le domaine 52 d'autre part. Dans cet exemple, l'élément semi-conducteur 33 est en contact avec la couche 16 dans le domaine 51 d'une part, et dans le domaine 52 d'autre part. L'élément semi-conducteur 33 comporte ainsi une portion 331 en contact avec la couche 16 dans le domaine 51, et une portion 332 en contact avec la couche 16 dans le domaine 52. Par ailleurs, l'élément semi-conducteur 33 s'étend en continu entre les portions 331 et 332, c'est-à-dire entre les domaines 51 et 52. L'élément semi-conducteur 33 est ici formé de façon à recouvrir l'élément isolant 34. L'élément semi-conducteur 33 est en saillie latéralement au-delà de l'élément isolant 34, pour former les portions 331 et 332 en contact avec la couche 16. L'élément semi-conducteur 33 comporte une partie logée dans la tranchée 5, qui recouvre les parois latérales et la paroi de fond de l'élément isolant 34.

Le transistor 1 comprend en outre un isolant de grille 32 ménagé sur l'élément semi-conducteur 33. Le transistor 1 comporte par ailleurs une électrode de grille 31 ménagée sur l'isolant de grille 32. L'électrode de grille 31 est formée à l'aplomb de l'élément semi-conducteur 33. En particulier, la projection de l'électrode de grille 31 sur le substrat 11 selon une direction normale à ce substrat 11 inclut la projection de l'élément semi-conducteur 33 sur ce substrat 11 selon la direction normale à ce substrat 11. Ainsi, l'élément semi-conducteur 33 est bien positionné dans le champ électromagnétique de l'électrode de grille 31 lorsque celle-ci est polarisée. L'électrode de commande 31 peut être réalisée de façon connue en soi en métal (par exemple en TiN) ou en polysilicium dopé. L'électrode de grille 31 est isolée électriquement du drain 21 et de la source 22 par une couche d'isolant 18, la couche d'isolant 18 étant ici formée sur la couche 16 dans la continuité de l'isolant de grille 32. Un potentiel de commande est appliqué sélectivement sur l'électrode de grille 31 par l'intermédiaire d'un circuit de commande non illustré.

À la figure 1, le transistor 1 est illustré dans sa configuration à l'état ouvert ou bloqué. L'élément isolant 34 et l'élément semi-conducteur 33 rendent le transistor 1 de type normalement ouvert, la conduction entre les domaines 51 et 52 étant interrompue lorsqu'un potentiel appliqué sur l'électrode de grille 31 est inférieur à la tension seuil. L'élément isolant 34 forme de fait une isolation électrique entre les domaines 51 et 52 de la superposition des couches 15 et 16. L'élément semi-conducteur 33 assure de fait une isolation électrique entre ses portions 331 et 332 lorsque le potentiel sur l'électrode de grille 31 est inférieur à la tension seuil. Le transistor 1 est donc bien de type normalement ouvert.

La distance entre les portions 331 et 332 est typiquement inférieure à 1 µm en vue de limiter le chemin de conduction dans la couche d'inversion. Par ailleurs, on peut noter que les portions 331 et 332 de l'élément semi-conducteur 33 induisent une déplétion locale dans les couches 16 et 15 de par la nature « pin » des jonctions formées par l'empilement des couches 33/16/15 à ces endroits. Une déplétion 41 est ainsi formée sous la portion 331, et une déplétion 42 est ainsi formée sous la portion 332. Sous la tranchée 5, la couche 14 à dopage de type P forme une barrière arrière pour bloquer une conduction entre les domaines 51 et 52, en l'absence de polarisation sur l'électrode de grille 31. La couche 14 contribue ainsi à la limitation du courant de fuite latéral du transistor 1 à l'état bloqué. Il est à noter que le courant de fuite latéral sera fortement limité de par :
- l'absence d'un canal d'électrons dans la couche 33 de type p à polarisation de grille sous le seuil ;
- l'emploi de plaques de champ dans l'espace grille-drain dont l'homme du métier a bien connaissance. Ces plaques de champ (non illustrées) ont pour but d'accompagner la déplétion latérale du gaz bidimensionnel d'électrons dans l'espace grille-drain à l'état bloqué, à mesure que la tension de drain augmente. La zone de charge d'espace ainsi créée dans l'espace grille-drain est un fort contributeur à la limitation des courants de fuites latéraux.

À la figure 2, le transistor 1 est illustré dans sa configuration à l'état fermé ou passant. Par application d'un potentiel supérieur à la tension de seuil sur l'électrode de grille 31, on forme un canal d'inversion dans l'élément semi-conducteur 33. L'élément semi-conducteur 33 permet alors le passage des électrons depuis les zones 51 à 52. Un chemin de conduction électronique est ainsi créé entre la portion 331 et la portion 332 à travers l'élément semi-conducteur 33. Les couches de gaz d'électrons des domaines 51 à 52 se trouvent ainsi reliées par un chemin de conduction de type n. Une conduction est ainsi assurée entre le drain 21 et la source 22 (comme illustré par le trait discontinu). On peut également noter que le champ appliqué sur l'électrode de grille 31 supprime les zones de déplétion 41 et 42 sous les portions 331 et 332.

Dans le mode de réalisation illustré, un potentiel sur l'électrode de grille 31 supérieur à la tension de seuil peut également permettre de former une liaison conductrice dans la couche 14 sous la tranchée 5. Une telle jonction conductrice à l'état passant du transistor 1 permet ainsi de réduire sa résistance à l'état passant. Une telle jonction conductrice à l'état passant peut par exemple être obtenue avec un élément isolant 34, un élément semi-conducteur 33 et un isolant de grille 32 suffisamment fins.

Lorsque les couches 15 et 16 sont formées par épitaxie, l'élément semi-conducteur 33 peut avantageusement être formé en dehors du bâti d'épitaxie bien qu'une reprise d'épitaxie de type pGaN soit possible (coûteuse et complexe). En particulier, un élément semi-conducteur 33 peut aisément être formé sur l'élément isolant 34 en dehors d'un bâti d'épitaxie, par exemple à partir d'un dépôt par pulvérisation cathodique réactive(pour du NiO par exemple) ou d'un dépôt en phase vapeur (pour du Polysilicium par exemple).

La couche 15, intrinsèque dans son volume et de type n proche de l'interface avec la couche 16 (lieu du canal d'électrons) forme avec la couche 14, une jonction de type NiP. Ainsi, du domaine 51 au domaine 52, deux jonctions NiP sont reliées têtes bêches sous l'élément isolant 34, configuration naturellement bloquante en l'absence de polarisation sur l'électrode de grille 31.

La tranchée 5 présente avantageusement une profondeur d'au moins 100 nm (mesurée entre la face supérieure de la couche 16 et le fond de la tranchée 5). La tranchée 5 présente avantageusement une largeur d'au plus 1 µm.

L'élément isolant 34 est par exemple réalisé en Al₂O₃, SiO₂ ou en SiN. L'élément isolant 34 présente typiquement une épaisseur comprise entre 10 nm et 200 nm.

Le choix de l'élément semi-conducteur 33 de type p vise à répondre aux critères de choix suivants :
- 1. Grande bande interdite et capacité de dopage à fortes concentrations (1x10¹⁸ cm⁻³.) : cela favorise l'obtention d'une tension de seuil élevée (selon la Théorie MOSFET)
- 2. Propriétés de conduction de l'élément 33, on recherche une résistivité faible : Ainsi l'élement 33 n'introduit pas une résistance série importante, ce qui évite d'affecter le courant à l'état passant du transistor.
- 3. Barrière de potentiel GaN canal/Semiconducteur 33. L'affinité électronique du GaN et de l'élément semiconducteur 33 doivent être proches (ou présenter des bandes de conduction quasi alignées) : cela Evite la formation d'une barrière de potentiel au passage entre le GaN et l'élément 33, qui réduirait le courant à l'état passant du transistor.
Satisfaire ces différents critères est difficile.
Le p- NiO est favorable pour le critère 1, voire le 2.
Le p-PolySi est favorable selon les critères 2 et 3. Ce matériau remplit en partie le critère 1 (faible bande interdite mais fort dopage). Le choix du p-PolySi sera généralement favorisé.
Le p-GaN est favorable selon les critères 1 et 3.

L'élément semi-conducteur 33 est par exemple formé à partir d'un dépôt de NiO, matériau naturellement dopé P. Le NiO sera par exemple privilégié pour un transistor 1 devant présenter une tension de seuil élevée de par sa bande interdite élevée (3.4 eV) et la faculté de le doper fortement p (>1x10¹⁸ cm⁻³).. L'élément semi-conducteur 33 peut également être formé à partir d'un dépôt de polysilicium dopé P. Un dépôt de polysilicium sera par exemple privilégié pour favoriser une mobilité électronique accrue dans l'élément semi-conducteur 33 à l'état passant. Le polysilicium peut en effet être dopé avec des concentrations élevées en dopage de type P. La concentration du dopage de type P dans l'élément 33 en polysicilium est avantageusement comprise entre 2*10¹⁷cm⁻³ et 1*10¹⁸cm⁻³, et avantageusement comprise entre 3*10¹⁷cm⁻³ et 8*10¹⁷cm⁻³. Le polysilicium présente en outre une meilleure compatibilité à l'interface des portions 331 et 332 avec une couche 16 en AlGaN. La bande interdite du polysilicium est typiquement de l'ordre de 1,1 eV. D'autres matériaux semiconducteurs à dopage de type P pourront également être envisagés, par exemple du diamant de type P. L'élément semi-conducteur 33 présente typiquement une épaisseur comprise entre 50 et 150 nanomètres.

L'isolant de grille 32 présente typiquement une épaisseur comprise entre 20 et 60 nanomètres, par exemple de 30 nm. L'isolant de grille 32 peut être formé en un matériau tel que du SiO₂ ou du Al₂O₃.

Dans le premier mode de réalisation illustré, on souhaite également pouvoir réaliser une jonction conductrice sous la tranchée 5 à l'état passant du transistor 1. À cet effet, on utilise avantageusement un élément isolant fin 34 présentant une épaisseur de 30 nm par exemple, et un élément semi-conducteur 33 relativement fin, d'épaisseur typiquement inférieure à 100 nm par exemple. L'isolant de grille 32 présentera également de préférence une épaisseur d'environ 30 nm. La tranchée 5 présentera avantageusement une profondeur inférieure à 100 nm, de préférence inférieure à 80 nm.

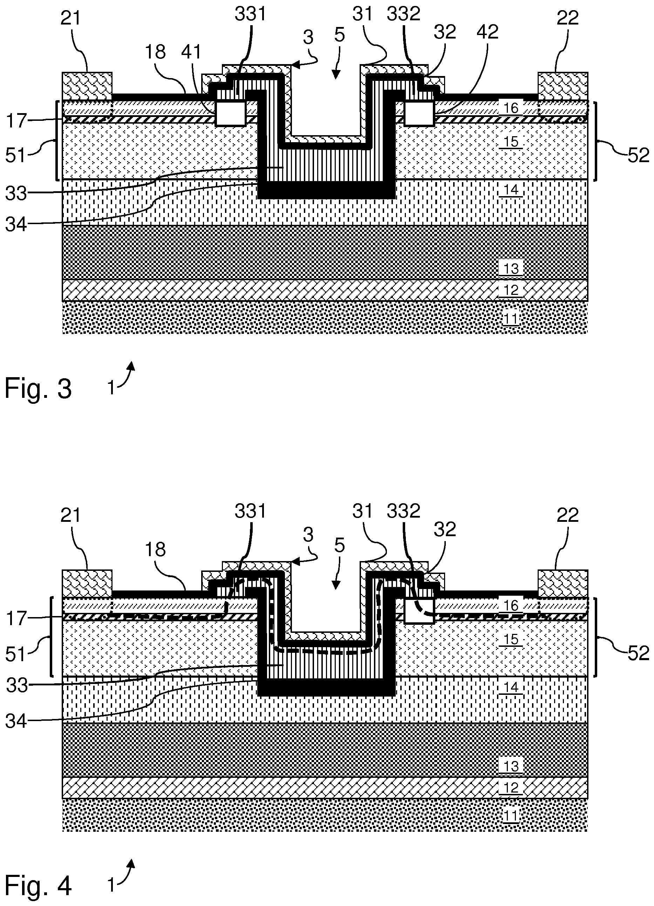

La figure 3 est une vue en coupe transversale d'un transistor à haute mobilité électronique 1 de type normalement ouvert selon un exemple d'un deuxième mode de réalisation de l'invention. À la figure 4, le transistor 1 est illustré à l'état passant. Le trait discontinu de la figure 4 illustre le chemin de conduction.

Dans le deuxième mode de réalisation, on souhaite pouvoir bloquer la formation d'une jonction conductrice sous une tranchée 5, même à l'état passant du transistor 1. Dans ce deuxième mode de réalisation, le transistor 1 comporte les éléments suivants, identiques à ceux du premier mode de réalisation :
- le substrat 11 ;
- la couche d'adaptation ;
- la couche de matériau semi-conducteur 12 ;
- la couche de matériau semi-conducteur 13.

Le transistor 1 comporte avantageusement une couche 14 en matériau semi-conducteur de type alliage III-V (par exemple identique à celui du premier mode de réalisation) à dopage de type P. La couche 14 forme une barrière arrière ou barrière enterrée. La couche 14 permet de réduire la conduction parasite d'électrons en profondeur. La couche 14 est ici disposée sur la couche 13.

Le transistor 1 comporte une couche 15 en matériau semi-conducteur de type alliage III-V (par exemple identique à celui du premier mode de réalisation), formée sur la couche 14. La couche 15 peut présenter une épaisseur telle que décrite pour le premier mode de réalisation, ou une épaisseur supérieure.

Le transistor 1 comporte en outre une couche 16 en matériau semi-conducteur de type alliage III-V (par exemple identique à celui du premier mode de réalisation). La couche 16 peut présenter une épaisseur telle que décrite pour le premier mode de réalisation. Les couches semi-conductrices 15 et 16 sont superposées de façon connue en soi pour former une couche de gaz d'électrons 17 à l'interface ou à proximité de l'interface entre ces couches 15 et 16.

Le transistor 1 comporte en outre un drain 21 formé en contact sur la couche 16 et connecté électriquement à la couche de gaz d'électrons 17. Le transistor 1 comporte en outre une source 22 formée en contact sur la couche 16 et connectée électriquement à la couche de gaz d'électrons 17.

Le transistor 1 comporte en outre une grille de commande 3, le drain 21 et la source 22 étant disposés de part et d'autre de la grille de commande 3. Une tranchée 5 est formée sous la grille de commande 3 et traverse les couches 15 et 16, en interrompant ainsi la couche de gaz d'électrons 17. La tranchée 5 sépare ainsi la superposition des couches 15 et 16 et la couche de gaz d'électrons 17 en deux domaines disjoints 51 et 52. La tranchée 5 s'étend ici jusque dans la couche 14 à dopage de type P. La tranchée 5 peut même s'étendre au-delà de la couche 14.

Le transistor 1 comporte un élément de matériau isolant 34, isolant électriquement les domaines 51 et 52 de la superposition des couches 15 et 16. L'élément 34 interrompt notamment la couche de gaz électrons 17 entre les domaines 51 et 52, recouvre les parois latérales de la tranchée 5 et est donc en contact avec des faces latérales des couches 15 et 16. L'élément 34 recouvre ici la paroi de fond de la tranchée 5, et est donc en contact avec la couche 14 au fond de la tranchée 5. L'élément 34 comporte également des rebords recouvrant une partie de la couche 16 dans les domaines 51 et 52 respectivement.

Le transistor 1 comprend en outre un élément semi-conducteur 33 à dopage de type P en contact avec la couche 16 dans le domaine 51 d'une part, et dans le domaine 52 d'autre part. L'élément semi-conducteur 33 comporte ainsi une portion 331 en contact avec la couche 16 dans le domaine 51, et une portion 332 en contact avec la couche 16 dans le domaine 52. Par ailleurs, l'élément semi-conducteur 33 s'étend en continu entre les portions 331 et 332, c'est-à-dire entre les domaines 51 et 52. L'élément semi-conducteur 33 est ici formé de façon à recouvrir l'élément isolant 34. L'élément semi-conducteur 33 est en saillie latéralement au-delà de l'élément isolant 34, pour former les portions 331 et 332 en contact avec la couche 16. L'élément semi-conducteur 33 comporte une partie logée dans la tranchée 5, qui recouvre les parois latérales et la paroi de fond de l'élément isolant 34.

Le transistor 1 comprend en outre un isolant de grille 32 ménagé sur l'élément semi-conducteur 33. Le transistor 1 comporte par ailleurs une électrode de grille 31 ménagée sur l'isolant de grille 32. L'électrode de grille 31 est formée à l'aplomb de l'élément semi-conducteur 33. En particulier, la projection de l'électrode de grille 31 sur le substrat 11 selon une direction normale à ce substrat 11 inclut la projection de l'élément semi-conducteur 33 sur ce substrat 11 selon la direction normale à ce substrat 11. Ainsi, l'élément semi-conducteur 33 est bien positionné dans le champ électromagnétique de l'électrode de grille 31 lorsque celle-ci est polarisée. L'électrode de commande 31 peut être réalisée dans le même matériau que pour le premier mode de réalisation. L'électrode de grille 31 est isolée électriquement du drain 21 et de la source 22 par une couche d'isolant 18, formée sur la couche 16 dans la continuité de l'isolant de grille 32. Un potentiel de commande est appliqué sélectivement sur l'électrode de grille 31 par l'intermédiaire d'un circuit de commande non illustré.

À la figure 3, le transistor 1 est illustré dans sa configuration à l'état ouvert ou bloqué. L'élément isolant 34 et l'élément semi-conducteur 33 rendent le transistor 1 de type normalement ouvert, la conduction entre les domaines 51 et 52 étant interrompue lorsqu'un potentiel appliqué sur l'électrode de grille 31 est inférieur à la tension seuil. Par ailleurs, on peut noter que les portions 331 et 332 de l'élément semi-conducteur 33 peuvent induire un champ dans la couche 16, conduisant à une déplétion locale et à une isolation électrique supplémentaire, ici au niveau de l'interface entre les portions 331, 332 et la couche 16. Une déplétion 41 est ainsi formée sous la portion 331, et une déplétion 42 est ainsi formée sous la portion 332.

À la figure 4, le transistor 1 est illustré dans sa configuration à l'état fermé ou passant. Par application d'un potentiel supérieur à la tension seuil sur l'électrode de grille 31, on forme un canal d'inversion dans l'élément semi-conducteur 33. L'élément semi-conducteur 33 devient alors conducteur. Un chemin de conduction est ainsi créé entre la portion 331 et la portion 332 à travers l'élément semi-conducteur 33. Une connexion électrique est ainsi créée entre la couche de gaz d'électrons 17 des domaines 51 et 52. Une conduction est ainsi assurée entre le drain 21 et la source 22 (comme illustré par le trait discontinu).

Par rapport au premier mode de réalisation, le transistor 1 comporte ici :
- une tranchée 5 plus profonde, par exemple pour une couche 15 plus épaisse. Une telle couche 15 plus épaisse permet d'augmenter la distance entre la couche de gaz d'électrons 17 et le fond de la tranchée 5, de sorte que la résistance est accrue si une conduction devait être formée sous la tranchée 5. On peut également envisager une couche 15 de même épaisseur et une couche 14 plus épaisse ;
- l'épaisseur de l'élément isolant 34 et/ou de l'élément semi-conducteur 33 est accrue, de sorte que dans la couche 14 sous la tranchée 5, le champ électromagnétique appliqué par l'électrode de grille 31 polarisée à la tension de seuil ne soit pas suffisant pour former un canal d'inversion. L'application d'une tension de seuil sur l'électrode de grille 31 ne permet alors pas d'obtenir une conduction sous la tranchée 5 par l'intermédiaire de la couche 14.

La tranchée 5 peut présenter une profondeur supérieure à 200 nm et s'étendre au-delà des couches 14 et 15 en profondeur.

L'épaisseur de l'élément 34 est de 100 nm par exemple.

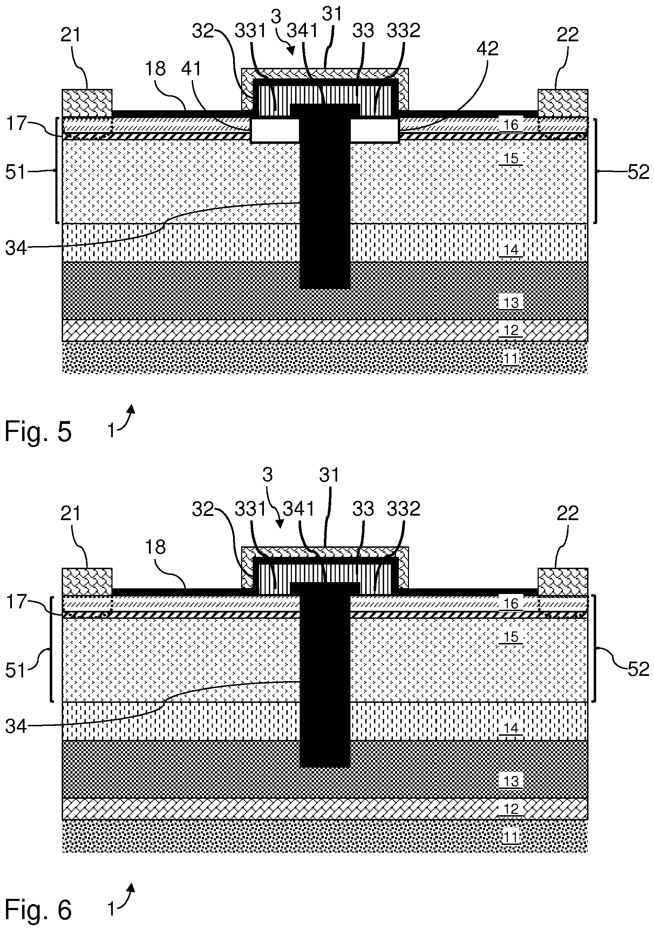

La figure 5 est une vue en coupe transversale d'un transistor à haute mobilité électronique 1 de type normalement ouvert selon un exemple d'un troisième mode de réalisation de l'invention. À la figure 6, le transistor 1 est illustré à l'état passant.

Dans le troisième mode de réalisation, on souhaite pouvoir bloquer la formation d'une jonction conductrice sous une tranchée, même à l'état passant du transistor 1. Dans ce troisième mode de réalisation, le transistor 1 comporte les éléments suivants, identiques à ceux du premier mode de réalisation :
- le substrat 11 ;
- la couche d'adaptation ;
- la couche de matériau semi-conducteur 12.

Le transistor 1 comporte avantageusement une couche 13 en matériau semi-conducteur de type alliage III-V (par exemple un alliage binaire de type III-V, par exemple en nitrure d'élément III, typiquement du GaN). La couche 13 peut par exemple être de type non intentionnellement dopé ou à dopage de type N. La couche 13 est ici disposée sur la couche tampon 12.

Le transistor 1 comporte avantageusement une couche 14 en matériau semi-conducteur de type alliage III-V (par exemple identique à celui du premier mode de réalisation) à dopage de type P. La couche 14 forme une barrière arrière ou barrière enterrée. La couche 14 permet de réduire la conduction parasite d'électrons en profondeur. La couche 14 est ici disposée sur la couche 13.

Le transistor 1 comporte une couche 15 en matériau semi-conducteur de type alliage III-V (par exemple identique à celui du premier mode de réalisation), formée sur la couche 14. La couche 15 présente avantageusement une épaisseur au moins égale à 50nm.

Le transistor 1 comporte en outre une couche 16 en matériau semi-conducteur de type alliage III-V (par exemple identique à celui du premier mode de réalisation). La couche 16 peut présenter une épaisseur telle que décrite pour le premier mode de réalisation. Les couches semi-conductrices 15 et 16 sont superposées de façon connue en soi pour former une couche de gaz d'électrons 17 à l'interface ou à proximité de l'interface entre ces couches 15 et 16.

Le transistor 1 comporte en outre un drain 21 formé en contact sur la couche 16 et connecté électriquement à la couche de gaz d'électrons 17. Le transistor 1 comporte en outre une source 22 formée en contact sur la couche 16 et connectée électriquement à la couche de gaz d'électrons 17.

Le transistor 1 comporte en outre une grille de commande 3, le drain 21 et la source 22 étant disposés de part et d'autre de la grille de commande 3. Une tranchée est formée sous la grille de commande 3 et traverse les couches 15 et 16, en interrompant ainsi la couche de gaz d'électrons 17. La tranchée sépare ainsi la superposition des couches 15 et 16 et la couche de gaz d'électrons 17 en deux domaines disjoints 51 et 52. La tranchée traverse également la couche 14 à dopage de type P. La tranchée s'étend ici jusque dans la couche 13. La tranchée présente avantageusement une profondeur d'au moins 200nm.

Le transistor 1 comporte un élément de matériau isolant 34, isolant électriquement les domaines 51 et 52 de la superposition des couches 15 et 16. L'élément 34 interrompt notamment la couche de gaz électrons 17 entre les domaines 51 et 52. L'élément 34 remplit la tranchée pour recouvrir ses parois latérales (et est donc en contact avec des faces latérales des couches 15 et 16) et recouvrir sa paroi de fond. L'élément 34 est donc en contact avec la couche 13. L'élément 34 comporte une saillie 341, dépassant verticalement de la tranchée. La saillie 341 dépasse ainsi verticalement de la face supérieure de la couche 16. L'élément 34 comporte également des rebords recouvrant une partie de la couche 16 dans les domaines 51 et 52 respectivement. L'élément isolant 34 peut être formé en matériau isolant tel que du SiO₂ ou du Al₂O₃. L'élément isolant 34 peut également être formé en matériau semi-conducteur soumis à une implantation d'Argon directement dans les couches III-N, permettant une isolation, sans nécessiter une gravure, un dépôt de semiconducteur et une implantation ultérieurs.

Le transistor 1 comprend en outre un élément semi-conducteur 33 à dopage de type P en contact avec la couche 16 dans le domaine 51 d'une part, et dans le domaine 52 d'autre part. L'élément semi-conducteur 33 comporte ainsi une portion 331 en contact avec la couche 16 dans le domaine 51, et une portion 332 en contact avec la couche 16 dans le domaine 52. Par ailleurs, l'élément semi-conducteur 33 s'étend en continu entre les portions 331 et 332, c'est-à-dire entre les domaines 51 et 52. L'élément semi-conducteur 33 est ici formé de façon à recouvrir l'élément isolant 34 et en particulier la saillie 341. L'élément semi-conducteur 33 est intégralement positionné au-dessus de la couche 16 et ne comporte aucune partie logée dans la tranchée. L'élément semi-conducteur 33 est en saillie latéralement au-delà de l'élément isolant 34, pour former les portions 331 et 332 en contact avec la couche 16.

Le transistor 1 comprend en outre un isolant de grille 32 ménagé sur l'élément semi-conducteur 33. Le transistor 1 comporte par ailleurs une électrode de grille 31 ménagée sur l'isolant de grille 32. L'électrode de grille 31 est formée à l'aplomb de l'élément semi-conducteur 33. En particulier, la projection de l'électrode de grille 31 sur le substrat 11 selon une direction normale à ce substrat 11 inclut la projection de l'élément semi-conducteur 33 sur ce substrat 11 selon la direction normale à ce substrat 11. Ainsi, l'élément semi-conducteur 33 est bien positionné dans le champ électromagnétique généré par l'électrode de grille 31 lorsque celle-ci est polarisée. L'électrode de commande 31 peut être réalisée dans le même matériau que pour le premier mode de réalisation. L'électrode de grille 31 est isolée électriquement du drain 21 et de la source 22 par une couche d'isolant 18, formée sur la couche 16 dans la continuité de l'isolant de grille 32. Un potentiel de commande est appliqué sélectivement sur l'électrode de grille 31 par l'intermédiaire d'un circuit de commande non illustré.

À la figure 5, le transistor 1 est illustré dans sa configuration à l'état ouvert ou bloqué. L'élément isolant 34 et l'élément semi-conducteur 33 rendent le transistor 1 de type normalement ouvert, la conduction entre les domaines 51 et 52 étant interrompue lorsqu'un potentiel appliqué sur l'électrode de grille 31 est inférieur à la tension seuil. Par ailleurs, on peut noter que les portions 331 et 332 de l'élément semi-conducteur 33 peuvent induire un champ dans la couche 16, conduisant à une déplétion locale et à une isolation électrique supplémentaire, ici au niveau de l'interface entre les portions 331, 332 et la couche 16. Une déplétion 41 est ainsi formée sous la portion 331, et une déplétion 42 est ainsi formée sous la portion 332. Par ailleurs, du fait de la profondeur de la tranchée, une conduction parasite dans la couche 13 sous cette tranchée est fortement réduite.

À la figure 6, le transistor 1 est illustré dans sa configuration à l'état fermé ou passant. Par application d'un potentiel supérieur à la tension seuil sur l'électrode de grille 31, on forme un canal d'inversion dans l'élément semi-conducteur 33. L'élément semi-conducteur 33 devient alors conducteur. Un chemin de conduction est ainsi créé entre la portion 331 et la portion 332 à travers l'élément semi-conducteur 33, au-dessus de la saillie 341. Une connexion électrique est ainsi créée entre la couche de gaz d'électrons 17 des domaines 51 et 52. Une conduction est ainsi assurée entre le drain 21 et la source 22. A contrario, la conduction dans la couche 13 sous la tranchée est empêchée, notamment du fait de la profondeur de la tranchée, et du fait de la distance entre l'élément semi-conducteur 33 et le fond de la tranchée, le champ électromagnétique appliqué par l'électrode de grille 31 sur la couche 13 sous la tranchée étant extrêmement réduit.

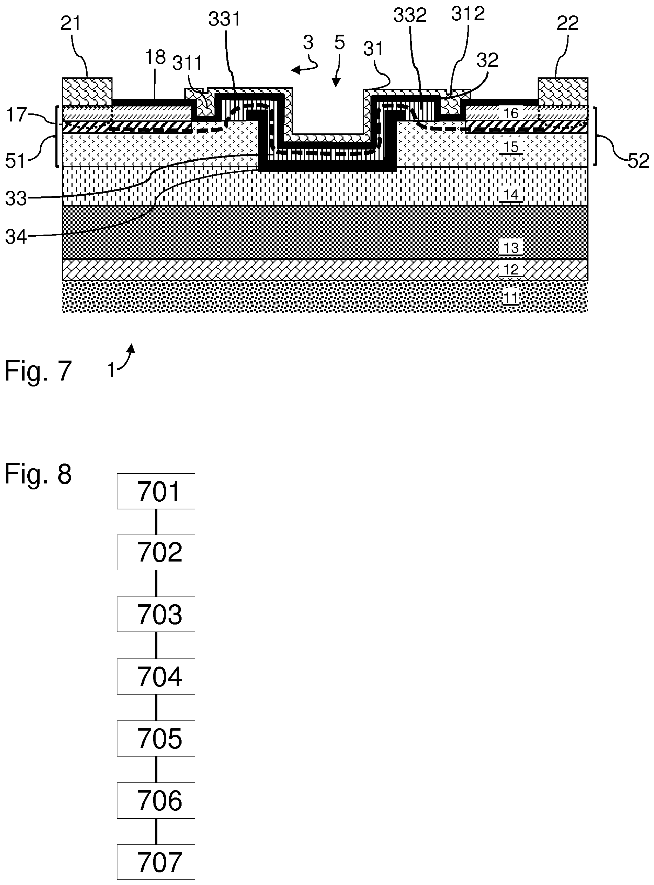

La figure 7 est une vue en coupe transversale d'un transistor à haute mobilité électronique 1 de type normalement ouvert selon un exemple d'un deuxième mode de réalisation de l'invention.

Dans ce quatrième mode de réalisation, le transistor 1 comporte les éléments suivants, identiques à ceux du premier mode de réalisation :
- le substrat 11 ;
- la couche d'adaptation ;
- la couche de matériau semi-conducteur 12 ;
- la couche de matériau semi-conducteur 13 ;
- la couche de matériau semi-conducteur 14 ;
- la couche de matériau semi-conducteur 15.

Le transistor 1 comporte en outre une couche 16 en matériau semi-conducteur de type alliage III-V (par exemple identique à celui du premier mode de réalisation). La couche 16 peut présenter une épaisseur telle que décrite pour le premier mode de réalisation. Les couches semi-conductrices 15 et 16 sont superposées de façon connue en soi pour former une couche de gaz d'électrons 17 à l'interface ou à proximité de l'interface entre ces couches 15 et 16.

Le transistor 1 comporte en outre un drain 21 formé en contact sur la couche 16 et connecté électriquement à la couche de gaz d'électrons 17. Le transistor 1 comporte en outre une source 22 formée en contact sur la couche 16 et connectée électriquement à la couche de gaz d'électrons 17.

Le transistor 1 comporte en outre une grille de commande 3, le drain 21 et la source 22 étant disposés de part et d'autre de la grille de commande 3. Une tranchée 5 est formée sous la grille de commande 3 et traverse les couches 15 et 16, en interrompant ainsi la couche de gaz d'électrons 17. La tranchée 5 sépare ainsi la superposition des couches 15 et 16 et la couche de gaz d'électrons 17 en deux domaines disjoints 51 et 52. La tranchée 5 s'étend ici jusque dans la couche 14 à dopage de type P. La tranchée 5 peut même s'étendre au-delà de la couche 14.

Le transistor 1 comporte un élément de matériau isolant 34, isolant électriquement les domaines 51 et 52 de la superposition des couches 15 et 16. L'élément 34 recouvre les parois latérales de la tranchée 5 et est donc en contact avec des faces latérales de la couche 15. L'élément 34 recouvre ici la paroi de fond de la tranchée 5, et est donc en contact avec la couche 14 au fond de la tranchée 5. L'élément 34 comporte également des rebords recouvrant une partie de la couche 15 dans les domaines 51 et 52 respectivement.

Le transistor 1 comprend en outre un élément semi-conducteur 33 à dopage de type P en contact avec la couche 15 dans le domaine 51 d'une part, et dans le domaine 52 d'autre part. L'élément semi-conducteur 33 comporte ainsi une portion 331 en contact avec la couche 15 dans le domaine 51, et une portion 332 en contact avec la couche 15 dans le domaine 52. Par ailleurs, l'élément semi-conducteur 33 s'étend en continu entre les portions 331 et 332, c'est-à-dire entre les domaines 51 et 52. L'élément semi-conducteur 33 est ici formé de façon à recouvrir l'élément isolant 34. L'élément semi-conducteur 33 est en saillie latéralement au-delà de l'élément isolant 34, pour former les portions 331 et 332 en contact avec la couche 15. L'élément semi-conducteur 33 comporte une partie logée dans la tranchée 5, qui recouvre les parois latérales et la paroi de fond de l'élément isolant 34.

Une partie de la couche 15 n'est pas recouverte par la couche 16, à la fois dans le domaine 51 et dans le domaine 52. Chacune de ces parties permet :
- de ménager un des rebords de l'élément 34 recouvrant une partie de la couche 15 ;
- de ménager un contact entre les portions 331 ou 332 de l'élément semi-conducteur 33 et la couche 15 ;
- de ménager un contact avec un isolant de grille 32.

Le transistor 1 comprend en outre un isolant de grille 32 ménagé sur l'élément semi-conducteur 33 et débordant jusqu'en contact avec la couche 15 et contre des faces latérales d'extrémité de l'élément semi-conducteur 33. Le transistor 1 comporte par ailleurs une électrode de grille 31 ménagée sur l'isolant de grille 32. L'électrode de grille 31 est formée à l'aplomb de l'élément semi-conducteur 33. En particulier, la projection de l'électrode de grille 31 sur le substrat 11 selon une direction normale à ce substrat 11 inclut la projection de l'élément semi-conducteur 33 sur ce substrat 11 selon la direction normale à ce substrat 11. En outre l'électrode de grille 31 comporte des débordements 311 et 312 recouvrant l'isolant de grille 32 qui est en contact avec la couche 15. Ces débordements 311 et 312 s'étendent ainsi en profondeur entre la couche 16 et les portions 331 et 332 respectivement. Ces débordements 311 et 312 permettent ainsi d'appliquer un champ électromagnétique latéralement sur les débordements 311 et 312.

Ainsi, l'élément semi-conducteur 33 est bien positionné dans le champ électromagnétique de l'électrode de grille 31 lorsque celle-ci est polarisée. L'électrode de commande 31 peut être réalisée dans le même matériau que pour le premier mode de réalisation. L'électrode de grille 31 est isolée électriquement du drain 21 et de la source 22 par une couche d'isolant 18, formée sur les couches 15 et 16 dans la continuité de l'isolant de grille 32. Un potentiel de commande est appliqué sélectivement sur l'électrode de grille 31 par l'intermédiaire d'un circuit de commande non illustré.

À la figure 7, le transistor 1 est illustré dans sa configuration à l'état ouvert ou bloqué. L'élément isolant 34 et l'élément semi-conducteur 33 rendent le transistor 1 de type normalement ouvert, la conduction entre les domaines 51 et 52 étant interrompue lorsqu'un potentiel appliqué sur l'électrode de grille 31 est inférieur à la tension seuil.

Par application d'un potentiel supérieur à la tension seuil sur l'électrode de grille 31, on forme :
- une accumulation d'électrons sous l'isolant de grille 32 en contact avec la couche 15. Un chemin de conduction est ainsi créé entre la couche de gaz d'électrons 17 et l'élément semi-conducteur 33 ;
- un canal d'inversion dans l'élément semi-conducteur 33. L'élément semi-conducteur 33 devient alors conducteur. Un chemin de conduction est ainsi créé entre la portion 331 et la portion 332 à travers l'élément semi-conducteur 33. Une connexion électrique est ainsi créée entre la couche de gaz d'électrons 17 des domaines 51 et 52. Une conduction est ainsi assurée entre le drain 21 et la source 22 (comme illustré par le trait discontinu).

La figure 8 est un logigramme illustrant différentes étapes d'un exemple de procédé de fabrication d'un transistor selon l'invention.

Lors d'une étape 701, on fournit au préalable une superposition d'une première couche de matériau semi-conducteur de type alliage III-V et d'une deuxième couche de matériau semi-conducteur de type alliage III-V, formant une couche de gaz d'électrons à l'interface ou à proximité de l'interface entre ces première et deuxième couches. Cette superposition des première et deuxième couches est par exemple formée de façon connue en soi, par exemple par épitaxie. Les première et deuxième couches sont par exemple formées sur un empilement de couches 11 à 14 telles que décrites en référence aux premier à quatrième modes de réalisation. Pour un procédé de fabrication d'un transistor à gaz d'électrons, la première couche est de type non intentionnellement dopé.

Lors d'une étape 702, on forme une tranchée séparant la superposition des première et deuxième couches en des premier et deuxième domaines disjoints. Le gaz d'électrons est interrompu par cette tranchée, qui traverse les première et deuxième couches. La formation de la tranchée peut être réalisée de façon connue en soi par photolithographie et gravure.

Lors d'une étape 703, on forme une couche d'isolant électrique de façon à recouvrir les parois latérales et le fond de la tranchée. La couche d'isolant peut être déposée pleine plaque, puis mise en forme par photolithograhie et gravure, de façon à former un élément isolant et à découvrir la surface supérieure de la deuxième couche de semi-conducteur, tout en conservant l'isolant dans la tranchée pour isoler les premier et deuxième domaines.

Lors d'une étape 704, on forme une couche de semi-conducteur de façon à recouvrir l'élément isolant. La couche de semi-conducteur est ensuite mise en forme par photolithographie et gravure, de façon à former un élément semi-conducteur comportant des portions en contact avec les premier et deuxième domaines de la superposition. Par ailleurs, l'élément semi-conducteur formé s'étend en continu sur l'élément isolant entre ces portions en contact. Cette couche de semi-conducteur est de préférence déposée de façon à présenter un dopage dès son dépôt (dopage de type P). Le dépôt de la couche de semi-conducteur est par exemple réalisé par une étape de pulvérisation cathodique réactive.

Lors d'une étape 705, on forme une couche d'isolant de grille de façon à recouvrir l'élément semi-conducteur.

Lors d'une étape 706, on forme une électrode de grille sur l'isolant de grille, à l'aplomb de l'élément semi-conducteur. La formation de l'électrode de grille peut inclure le dépôt d'une couche de polysilicium sur la couche d'isolant de grille, puis d'une couche d'un second isolant et d'un métal de grille et enfin la mise en forme de la couche déposée, par photolithographie.

Lors d'une étape 707 on connecte l'électrode de grille à un circuit de commande, configuré pour appliquer sélectivement un potentiel inférieur ou supérieur à la tension de seuil.

Les étapes de formation du drain et de la source du transistor étant connues en soi de l'homme du métier, elle ne sont pas détaillées dans le descriptif d'un procédé de fabrication d'un transistor selon l'invention.

## Revendications

1. Transistor à effet de champ (1) à haute mobilité électronique de type normalement ouvert, **caractérisé en ce qu'**il comprend :
- une superposition d'une première couche de matériau semi-conducteur (15) de type alliage III-V et d'une deuxième couche de matériau semi-conducteur (16) de type alliage III-V de façon à former une couche de gaz d'électrons (17) à l'interface ou à proximité de l'interface entre ces première et deuxième couches;
- une tranchée (5) séparant la superposition des première et deuxième couches de matériau semi-conducteur en des premier et deuxième domaines (51, 52) ;
- un élément isolant (34) disposé dans ladite tranchée de façon à isoler électriquement lesdits premier et deuxième domaines;
- un élément semi-conducteur (33) à dopage de type P en contact avec la première ou la deuxième couche de matériau semi-conducteur (16) des premier et deuxième domaines (51,52), et s'étendant en continu entre les premier et deuxième domaines sur ledit élément isolant (34) ;
- un isolant de grille (32) disposé sur l'élément semi-conducteur (33) ;
- une électrode de grille (31) disposée sur l'isolant de grille (32).

2. Transistor à effet de champ (1) selon la revendication 1, dans lequel l'élément semi-conducteur (33) à dopage de type P est en NiO dopé P.

3. Transistor à effet de champ (1) selon la revendication 1, dans lequel l'élément semi-conducteur (33) à dopage de type P est en Polysilicium dopé P.

4. Transistor à effet de champ (1) selon la revendication 1, dans lequel l'élément semi-conducteur (33) à dopage de type P est en GaN dopé P.

5. Transistor à effet de champ (1) selon l'une quelconque des revendications précédentes, dans lequel ledit élément semi-conducteur (33) à dopage de type P s'étend dans ladite tranchée (5).

6. Transistor à effet de champ (1) selon l'une quelconque des revendications 1 à 4, dans lequel ledit élément isolant (34) comporte une saillie (341) dépassant verticalement de la tranchée (5), et dans lequel ledit élément semi-conducteur (33) recouvre ladite saillie (341).

7. Transistor à effet de champ (1) selon la revendication 6, comprenant en outre une troisième couche de matériau semi-conducteur (14) à dopage de type P, sur laquelle ladite première couche est formée, ladite tranchée (5) s'étendant jusque dans ladite troisième couche de matériau semi-conducteur, dans lequel ladite tranchée (5) présente une profondeur au moins égale à 100 nm et dans lequel ladite première couche de matériau semi-conducteur (15) présente une épaisseur au moins égale à 70 nm.

8. Transistor à effet de champ (1) selon l'une quelconque des revendications 1 à 5, comprenant en outre une troisième couche de matériau semi-conducteur (14) à dopage de type P, sur laquelle ladite première couche est formée, ladite tranchée (5) s'étendant jusque dans ladite troisième couche de matériau semi-conducteur.

9. Transistor à effet de champ (1) selon les revendications 5 et 8, dans lequel l'élément semi-conducteur (33), l'élément isolant (34) et l'isolant de grille (32) sont suffisamment fins pour que l'application d'une tension de seuil sur l'électrode de grille (31) crée un canal de conduction par inversion dans la troisième couche de matériau semi-conducteur (14) sous ladite tranchée (5).

10. Transistor à effet de champ (1) selon l'une quelconque des revendications précédentes, dans lequel la première couche de matériau semi-conducteur (15) est en GaN.

11. Transistor à effet de champ (1) selon l'une quelconque des revendications précédentes, dans lequel la deuxième couche de matériau semi-conducteur (16) est en AIGaN.

12. Transistor à effet de champ (1) selon l'une quelconque des revendications précédentes, comprenant une première électrode de conduction (21) connectée électriquement au gaz d'électrons du premier domaine (51), et comprenant une deuxième électrode de conduction (22) connectée électriquement au gaz d'électrons du deuxième domaine (52).

13. Transistor à effet de champ (1) selon l'une quelconque des revendications précédentes, dans lequel ledit isolant de grille (32) présente une épaisseur au plus égale à 15nm et/ou dans lequel ledit élément semi-conducteur (33) comporte une concentration en dopant de type P au moins égale à 2*10¹⁷cm⁻³.

14. Système, comprenant :
- un transistor à effet de champ (1) selon l'une quelconque des revendications précédentes ;
- un circuit de commande configuré pour appliquer sélectivement une tension de commande sur ladite électrode de grille (31), l'amplitude de ladite tension de commande générant un canal d'inversion conducteur dans ledit élément semi-conducteur (33).

15. Procédé de fabrication d'un transistor à effet de champ à hétérojonction (1), comprenant les étapes de :
- fournir une superposition d'une première couche de matériau semi-conducteur (15, 65) de type alliage III-V et d'une deuxième couche de matériau semi-conducteur (16, 66) de type alliage III-V formant une couche de gaz d'électrons (17) ou une couche de gaz de trous (67) à l'interface ou à proximité de l'interface entre ces première et deuxième couches, une tranchée (5) séparant la superposition des première et deuxième couches de matériau semi-conducteur en des premier et deuxième domaines (51, 52), un élément isolant (34) étant disposé dans ladite tranchée (5) de façon à isoler électriquement lesdits premier et deuxième domaines de la superposition ;
- former un élément semi-conducteur (33) en contact avec la deuxième couche de matériau semi-conducteur des premier et deuxième domaines (51, 52) et s'étendant en continu entre les premier et deuxième domaines sur l'élément isolant, l'élément semi-conducteur (33) présentant un dopage de type P ;
- former un isolant de grille (32) sur l'élément semi-conducteur (33) ;
- former une électrode de grille (31) sur l'isolant de grille (32) à l'aplomb de l'élément semi-conducteur (33).
